# EUROPEAN PATENT SPECIFICATION

(11) **EP 2 698 537 B1**
(45) Date of publication and mention of the grant of the patent: **17.10.2018**
(21) Application number: 12771595.1
(22) Date of filing: 01.03.2012
(51) Int. Cl.: F04B 9/00, H01L 41/09

(54) **ACTUATOR-SUPPORT STRUCTURE AND PUMP DEVICE**
STELLGLIED-TRÄGERSTRUKTUR UND PUMPVORRICHTUNG
STRUCTURE SUPPORT D'ACTIONNEUR ET DISPOSITIF DE POMPE

(30) Priority: 11.04.2011 JP 2011087475
(43) Date of publication of application: 19.02.2014
(73) Proprietor: Murata Manufacturing Co., Ltd., Nagaokakyo-shi, Kyoto 617-8555 (JP)
(72) Inventor: HIRATA Atsuhiko, Nagaokakyo-shi Kyoto 617-8555 (JP); KODAMA Yukiharu, Nagaokakyo-shi Kyoto 617-8555 (JP); OMORI Kenta, Nagaokakyo-shi Kyoto 617-8555 (JP)
(74) Representative: Reeve, Nicholas Edward
(86) International application number: PCT/JP2012/055179
(87) International publication number: WO 2012/140967

(56) References cited:
- JP-A- 63 120 594
- JP-A- 63 120 594
- JP-A- 2001 323 879
- JP-A- 2001 323 879
- JP-A- 2006 287 968
- JP-A- 2006 287 968
- JP-A- 2006 295 147
- JP-A- 2006 295 147
- JP-A- 2007 146 778

## Description

### Technical Field

The present invention relates to an actuator support structure that supports an actuator which flexurally vibrates and a pump device that includes the actuator support structure and conveys fluid.

### Background Art

A thin pump device has been developed which is used for conveying air for a fuel cell system and others, and controls flow of fluid by using an actuator that flexurally vibrates (e.g., see International Publication No. WO 2008/069264 A1).

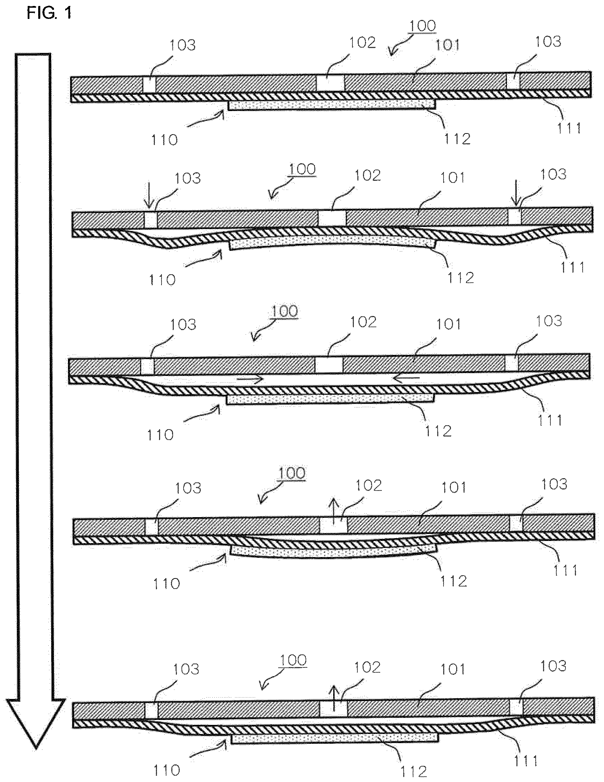

Fig. 1 is a diagram illustrating a configuration example of an existing pump device and its action.

The pump device 100 includes an actuator 110 composed of a vibration plate 111 and a piezoelectric element 112 and an opposed plate 101 disposed so as to be adjacent to and opposed to the vibration plate 111. The vibration plate 111 is made of metal and fixed at the entirety of an outer peripheral portion thereof to the opposed plate 101. The piezoelectric element 112 is attached to a centre portion of the vibration plate 111. The opposed plate 101 has a first opening 102 formed at a position that faces the centre of the actuator 110 and has a second opening 103 formed at a position that faces the actuator 110 so as to be out of the piezoelectric element 112. In this pump device, when a voltage of a predetermined frequency is applied to the piezoelectric element 112, the vibration plate 111 resonates in a third-order resonance mode, and in the vibration plate 111, a portion that faces the first opening 102 and a portion that faces the second opening 103 bend in opposite directions. By this bending being repeated, the pump device 100 sucks fluid through one of the first opening 102 and the second opening 103 and discharges the fluid through the other of the first opening 102 and the second opening 103.

An electronic apparatus into which a pump device is incorporated is always demanded to be reduced in size, and the pump device is also demanded to be reduced in size without reducing the pumping power (fluid pressure and flow rate). In addition, for the electronic apparatus, decrease in a power-supply voltage is also demanded, and for the pump device, decrease in a drive voltage is also demanded. However, the pumping power of the pump device tends to decrease as the size is reduced or the drive voltage is decreased. Thus, there are limits to the size reduction and the drive voltage decrease.

JP2006287968 discloses a pizoelectric speaker capable of flattening frequency characteristics and reducing a distortion component. JP2007146778 discloses a thin type bending oscillator and diaphraghm type pump maintaining water-proofing properties for a long period of time.

We have therefore appreciated that it would be desirable to provide a small-sized and low-height pump device having high pumping power.

We have further appreciated that it would be desirable to provide an actuator support configuration that has a structure suitable for such a pump device.

### SUMMARY OF THE INVENTION

The invention is defined by the independent claims to which reference should now be made. Advantageous features are set forth in the dependent claims.

According to the invention in a first aspect, there is provided a pump device comprising an actuator support structure, the actuator support structure comprising: a plate-shaped actuator which flexurally vibrates from a centre portion of a principal surface thereof to an outer peripheral portion thereof; a side wall which surrounds outside of an outer periphery of the actuator; and an elastic support portion which elastically supports the outer periphery of the actuator to the side wall, wherein the elastic support portion includes: a beam portion, having a substantially circular arc shape, which extends in a gap between the actuator and the side wall in a direction along the outer periphery of the actuator; an actuator connection portion which connects the beam portion to the actuator; and a side wall connection portion which is provided in a position offset from the actuator connection portion in the direction along the outer periphery of the actuator and connects the beam portion to the side wall; and wherein the side wall of the actuator support structure is included in a housing of the pump device, the housing also including an opposed wall which is located so as to be adjacent to and opposed to the principal surface of the actuator; and wherein the opposed wall is provided with a flow path hole in a centre of a region facing the actuator or in the vicinity of the centre, through which flow path hole a fluid flows in.

In the above mentioned aspect of the invention, the outer peripheral portion of the actuator is elastically supported to the side wall such as the housing via the elastic support portion. Thus, the outer peripheral portion of the actuator is not fixed as in the structure shown in Fig. 1, and the outer peripheral portion of the actuator is allowed to displace. In addition, the beam portion constituting the elastic support portion extends in the direction along the outer periphery of the actuator and the actuator connection portion and the side wall connection portion are located so as to be offset from each other. Thus, the beam portion can be formed in a substantially circular arc shape and a sufficient beam portion length can be ensured without folding back the beam portion. Therefore, the set range of the beam portion length can be wide without almost reducing the vibration plate in size (in area).

The beam portion may be configured to be connected to the actuator via the actuator connection portion at a position adjacent to a loop, or an antinode of natural vibrations when the side wall connection portion is a fixing portion. A natural vibration frequency of the natural vibrations then coincides with a natural vibration frequency of the actuator.

In the aspect of the invention mentioned above, two of the side wall connection portions may be connected to a respective end of the beam portion, and the actuator connection portion may be connected to a centre of the beam portion between both ends thereof.

In the above aspect of the invention, vibrations of the beam portion accompanying the flexural vibrations of the actuator are vibrations in a first-order resonance mode.

In the above-mentioned aspect of the invention, the actuator may have a disc shape.

In the above-mentioned aspect of the invention, the opposed wall may include: a thin portion which is provided on an outer periphery of the flow path hole and capable of flexurally vibrating; and a thick portion which is provided on an outer periphery of the thin portion.

According to the invention, the outer peripheral portion of the actuator is allowed to displace with flexural vibrations, the flexural vibrations of the actuator can be prevented from being damped by constraint from the side wall portion, and the amplitude of the flexural vibrations can be increased. Since the amplitude of the flexural vibrations of the actuator is increased, desired fluid pressure and flow rate can be efficiently obtained in the pump device even when a drive voltage is low.

In addition, the set range of the beam portion length can be wide without almost reducing the vibration plate in size (in area). Thus, various characteristic values such as the elastic modulus and the resonant frequency of the beam portion can be arbitrarily set. The larger the area of the vibration plate is, the higher the flow rate can be ensured in the pump device. Moreover, when various characteristic values such as the elastic modulus and the resonant frequency of the beam portion can be arbitrarily set, the amplitude of the flexural vibrations of the actuator can be increased by appropriately setting them.

Furthermore, if a moment load applied to the elastic support portion during driving is excessively high, the elastic support portion may break. For example, if the beam portion has a configuration to be folded back in its middle (e.g. a meander shape), a moment load is applied to the folded-back portion so as to open the beam portion in opposite directions, and the beam portion is at high risk of breakage at that position. For such a problem, in the above configuration of the present application, the actuator connection portion and the side wall connection portion are configured to be offset from each other. Thus, the beam portion can be formed in a substantially circular arc shape, the position to which the moment load is mainly applied is limited to the actuator connection portion or the side wall connection portion, and breakage of the beam portion can be prevented. By setting the length of connection with the actuator or the side wall to be relatively long, the actuator connection portion and the side wall connection portion can be made difficult to break.

The present inventors have found that when a state is provided in which the beam portion vibrates in an odd number-order resonance mode with flexural vibrations of the actuator, damping of the flexural vibrations can be effectively prevented. Therefore, when the elastic modulus and the resonant frequency of the beam portion and the like are appropriately set and the beam portion is vibrated in an odd number-order resonance mode, the beam portion is configured to be connected to the actuator at a position adjacent to the antinode of the resonance of the beam portion. In this state, damping of the flexural vibrations can be effectively prevented, and the amplitude of the flexural vibrations can be further increased.

Since the beam portion is supported in a double-supported structure, the actuator connection portion provided in the centre of the beam portion does not deform in a twisting manner, and breakage of the actuator connection portion can be prevented.

When the vibrations of the beam portion are in the first-order resonance mode, the vibration amplitude of the beam portion can be maximized and damping of the flexural vibrations of the actuator can be effectively prevented.

When the actuator has a disc shape, rotationally symmetrical (coaxial) flexural vibrations occur, and thus an unnecessary gap does not occur between the actuator and the opposed wall in the pump device and the operating efficiency is increased.

Since the thin portion capable of flexurally vibrating is provided in the opposed wall, the thin portion also vibrates with the vibrations of the actuator. Thus, the substantive vibration amplitude can be increased and the fluid pressure and flow rate can be increased in the pump device.

### BRIEF DESCRIPTION OF DRAWINGS

Fig. 1 is a diagram illustrating the configuration of an existing pump device and its action.
Fig. 2 is a schematic diagram of a piezoelectric pump according to a first embodiment of the present invention.
Fig. 3A is a schematic diagram illustrating the principle of action of the piezoelectric pump shown in Fig. 2.
Fig. 3B is a schematic diagram illustrating the principle of action of the piezoelectric pump shown in Fig. 2.
Fig. 4 is a perspective view of the piezoelectric pump shown in Fig. 2.
Fig. 5 is an exploded perspective view of the piezoelectric pump shown in Fig. 2.
Fig. 6 is a plan view of a leaf spring shown in Fig. 5.
Fig. 7 is a schematic cross-sectional view illustrating deformation of the leaf spring shown in Fig. 5.
Fig. 8 is a diagram showing fluid pressure-flow rate characteristics of the piezoelectric pump.
Fig. 9 is a plan view according to another configuration example of the leaf spring shown in Fig. 5.
Fig. 10 is an exploded perspective view of a piezoelectric pump according to a second embodiment of the present invention.

### DESCRIPTION OF EMBODIMENTS

Hereinafter, piezoelectric pumps that include piezoelectric elements will be described as examples of a pump device that includes an actuator support structure according to an embodiment of the present invention.

### First embodiment

First, a schematic configuration of a piezoelectric pump 1 according to a first embodiment of the present invention and its basic pumping action will be described.

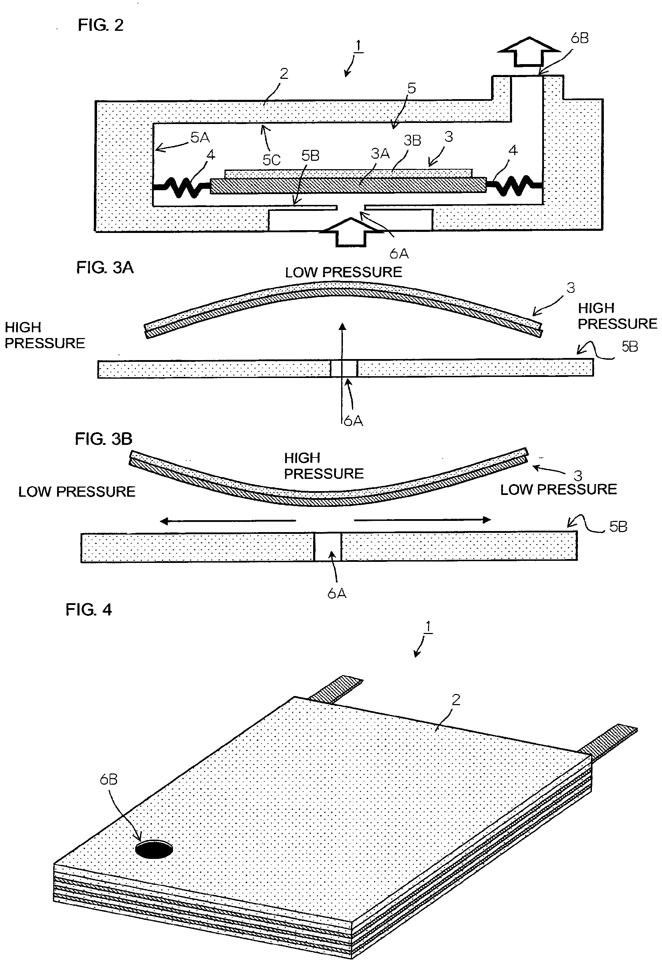

Fig. 2 is a schematic cross-sectional view of the piezoelectric pump 1 according to the first embodiment of the present invention during non-driving.

The piezoelectric pump 1 includes a housing 2, an actuator 3, and an elastic support portion 4.

The actuator 3 is configured by attaching a piezoelectric element 3B to a vibration plate 3A. In the piezoelectric element 3B, electrode films which are not shown are provided on substantially the entireties of upper and lower principal surfaces, respectively. The piezoelectric element 3B is configured to extensionally vibrate when, for example, a square-wave or sine-wave drive voltage of about 20 kHz is applied between these electrodes. Because of the configuration of the actuator 3 in which the piezoelectric element 3B is attached to the vibration plate 3A that is a rigid body, rotationally symmetrical (coaxial) flexural vibrations having a vibration direction that coincides with the principal surface normal direction occur from the principal surface centre to the outer periphery in the actuator 3.

The housing 2 has, as a flow path, an inner space 5 accommodating the actuator 3 and the elastic support portion 4 and flow path holes 6A and 6B communicating with the inner space 5. The inner space 5 is configured to include a cylindrical side wall 5A, a lower opposed wall 5B provided so as to close a lower opening of the side wall 5A, and an upper opposed wall 5C provided so as to close an upper opening of the side wall 5A. The flow path hole 6A is provided in the vicinity of the centre of a region of the lower opposed wall 5B which faces the lower principal surface of the actuator 3. The flow path hole 6B is provided at a position out of a region of the upper opposed wall 5C which faces the upper principal surface of the actuator 3 in the present embodiment.

The elastic support portion 4 connects the outer periphery of the actuator 3 to the side wall 5A and elastically supports the actuator 3 such that the lower principal surface of the actuator 3 is located so as to face the lower opposed wall 5B with a small interval or in a contact state during non-driving.

The piezoelectric pump 1 of the present embodiment employs the schematic configuration as described above.

Figs. 3A and 3B are schematic diagrams illustrating the basic pumping action of the piezoelectric pump 1. The actuator 3 moves so as to lift from the lower opposed wall 5B by being driven and each of a near-centre region and a near-outer periphery region of the actuator 3 vertically vibrates with a vibration amplitude of about several micrometers to several ten micrometers.

When the actuator 3 bends so as to be upwardly convex as shown in Fig. 3A, the gap between the actuator 3 and the lower opposed wall 5B increases in the vicinity of the centre of the actuator 3. Thus, the fluid pressure becomes low in the vicinity of the centre of the gap and hence the fluid attempts to flow in through the flow path hole 6A and the vicinity of the outer periphery of the gap. However, the interval in the vicinity of the outer periphery of the gap is narrow and the flow path resistance is high, and thus inflow of the fluid through the flow path hole 6A is dominant.

When the actuator 3 bends so as to be downwardly convex as shown in Fig. 3B, the gap between the actuator 3 and the lower opposed wall 5B decreases in the vicinity of the centre of the actuator 3. Thus, the fluid pressure becomes high in the vicinity of the centre of the gap and hence the fluid attempts to flow out through the flow path hole 6A and the vicinity of the outer periphery of the gap. However, the interval in the vicinity of the outer periphery of the gap is wide and the flow path resistance is low, and thus outflow of the fluid through the vicinity of the outer periphery of the gap is dominant.

The action described above is repeated with the resonant frequency of a first-order mode of the actuator 3, for example, with a frequency of about 20 kHz. By so doing, the fluid pressure in the gap in the vicinity of the centre of or in the vicinity of the outer periphery of the actuator 3 varies every second with the flexural vibrations of the actuator 3, but on a time average basis, negative pressure always occurs in the vicinity of the centre and positive pressure always occurs so as to counterbalance to the negative pressure. Because of this, the piezoelectric pump 1 sucks the fluid through the flow path hole 6A and discharges the fluid through the flow path hole 6B. It should be noted that in the piezoelectric pump 1, the flow path hole 6A may be opened to the air to perform positive pressure action, or the flow path hole 6B may be opened to the air to perform negative pressure action.

In addition, with this configuration, the average interval in the gap between the actuator 3 and the lower opposed wall 5B varies depending on variation of the pump load. In other words, in a state where the pump load is high, the pressure in the space located on a side of the actuator 3 opposite to the lower opposed wall 5B becomes high, and thus the average interval of the actuator 3 with respect to the lower opposed wall 5B is narrowed such that the spring force of the elastic support portion 4 balances out. On the other hand, in a state with the pump load is low, the pressure in the space located on the side of the actuator 3 opposite to the lower opposed wall 5B becomes low, and thus the average interval of the actuator 3 with respect to the lower opposed wall 5B is widened such that the spring force of the elastic support portion 4 balances out. Therefore, the size of the gap is autonomously adjusted in response to variation of the pump load.

Next, a specific configuration example of the piezoelectric pump 1 will be described. Fig. 4 is a perspective view of the piezoelectric pump 1. The piezoelectric pump 1 is configured by laminating a plurality of plate-shaped members, has, in an upper surface thereof, the flow path hole 6B for discharging fluid, and has a very low height with an entire thickness dimension of, for example, about 1 mm.

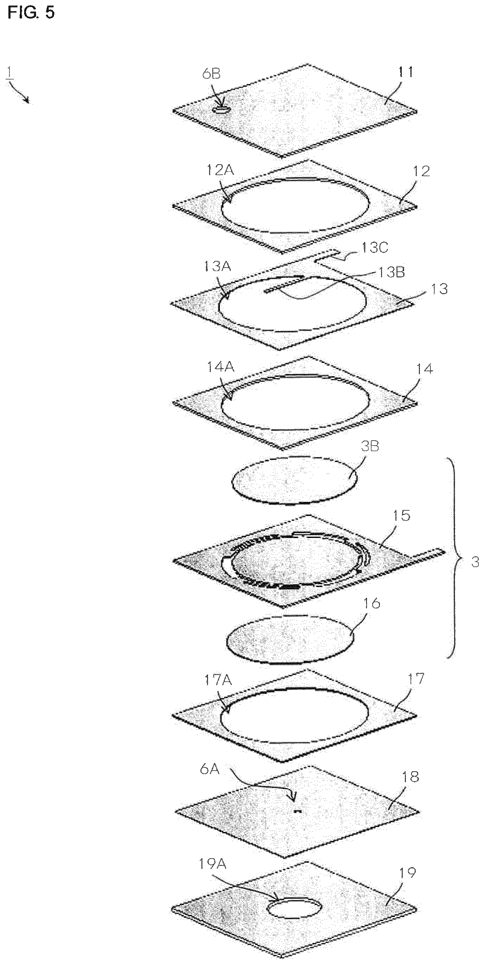

Fig. 5 is an exploded perspective view of the piezoelectric pump 1. The piezoelectric pump 1 includes a housing top plate 11, a spacer 12, a power-supply plate 13, an insulating spacer 14, the piezoelectric element 3B, a leaf spring 15, a reinforcing plate 16, a spacer 17, a thin metal plate 18, and a frame plate 19 in order from the upper surface side.

In this configuration example, a partial region of the leaf spring 15 constitutes the vibration plate 3A, the piezoelectric element 3B is joined to the upper surface of the region, and the reinforcing plate 16 is joined to the lower surface of the region, to form the aforementioned actuator 3. The reinforcing plate 16 is provided for enhancing the rigidity and adjusting the resonant frequency of the actuator 3.

It should be noted that in the actuator 3 having such a configuration, the members may be joined to each other by using a thermosetting adhesive, and in such a case, warpage may occur in the actuator 3 due to the difference in coefficient of linear expansion between the members. In order to prevent such warpage, the coefficient of linear expansion of each of the leaf spring 15, the piezoelectric element 3B, and the reinforcing plate 16 suffices to be selected such that thermal stress at the upper surface of the leaf spring 15 and thermal stress at the lower surface of the leaf spring 15 are balanced. In addition, if compressive stress is designed to be applied to the piezoelectric element 3B after the joining, the shock resistance of the piezoelectric element 3B can be enhanced and the piezoelectric element 3B can be made difficult to break. For that, it suffices that a material having a higher coefficient of linear expansion sufficiently than those of the piezoelectric element 3B and the reinforcing plate 16 is selected for the leaf spring 15. For example, it suffices that phosphor bronze, German silver, or nickel silver, or the like, which is a material having a high coefficient of linear expansion, is used for the leaf spring 15, and SUS430, which has a relatively low coefficient of linear expansion, is used for the reinforcing plate 16.

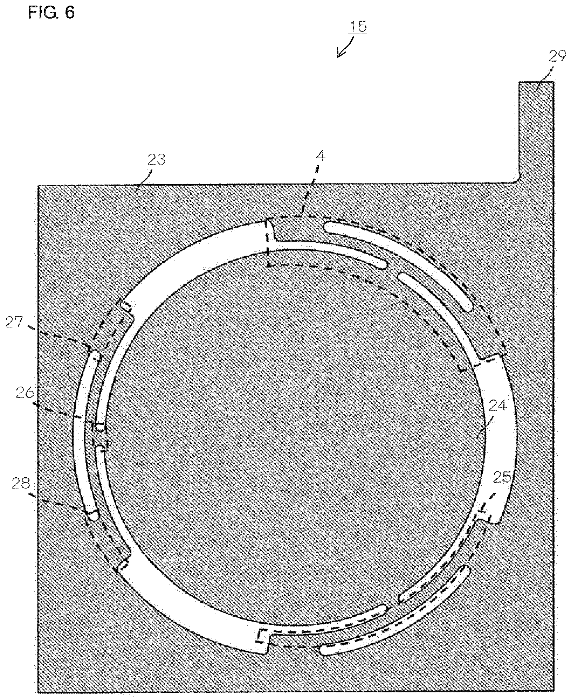

Fig. 6 is a plan view of the leaf spring 15. The leaf spring 15 is a rectangular plate made of metal and includes three elastic support portions 4, an outer frame portion 23, a disc portion 24, and an external connection terminal 29. It should be noted that the external connection terminal 29 projects outwardly from a corner in an outer periphery and is connected to a drive circuit, and a drive voltage for driving the aforementioned piezoelectric element 3B is applied thereto.

The outer frame portion 23 has a circular opening surrounding the circumference of the disc portion 24 and constitutes a portion of the aforementioned housing 2. The disc portion 24 has a circular shape and constitutes the actuator 3 together with the reinforcing plate 16 and the piezoelectric element 3B as described above. It should be noted that the actuator 3 is designed to have a natural vibration frequency of about 20 kHz, and is driven to resonate and flexurally vibrates when a drive voltage of the same frequency as this frequency is applied to the piezoelectric element 3B. The three elastic support portions 4 are provided in a gap (slit) between the outer frame portion 23 and the disc portion 24 at intervals of 120°.

Each elastic support portion 4 includes a beam portion 25 and connection portions 26, 27, and 28. The beam portion 25 extends in the gap between the outer frame portion 23 and the disc portion 24 along the outer circumference of the disc portion 24, is connected at both ends thereof to the outer frame portion 23 via the connection portions 27 and 28, and is connected at the centre thereof to the disc portion 24 via the connection portion 26. The beam portion 25 has a double-supported structure by the connection portions 27 and 28. By the elastic support portions 4 having such configurations, the disc portion 24 and the actuator 3 are elastically supported to the outer frame portion 23 and the housing 2.

When the disc portion 24 is connected to the outer frame portion 23 via the elastic support portions 4 as described above, a state where the outer circumference of the disc portion 24 is not substantially restrained, namely, a state where the actuator 3 is not substantially restrained by the housing 2, can be provided. This allows the actuator 3 to flexurally vibrate such that the interval between the vicinity of the outer periphery of the actuator 3 and the lower opposed wall 5B changes as shown in Figs. 3A and 3B. Accordingly, during driving, by the fluid pressure, the actuator 3 lifts from the vicinity of the lower opposed wall 5B and freely vibrates in a non-contact state with respect to the lower opposed wall 5B. A desired vibration amplitude of the actuator 3 is ensured, and high pressure and a high flow rate can be obtained even with a small-size and low-height structure. In addition, even when the frequency of the flexural vibrations of the actuator 3 is increased such that the actuator 3 is driven in a non-audible range of 20 kHz or higher, a sufficient vibration amplitude is obtained and a desired flow rate and fluid pressure can be ensured.

In addition, as shown in Fig. 6, each elastic support portion 4 is configured to have the beam portion 25 extending in the slit between the outer frame portion 23 and the disc portion 24 along the outer circumference of the disc portion 24, and the beam portion 25 is made to have a length in a wide set range without almost reducing the disc portion 24 in size (in area). Therefore, each elastic support portion 4 has high flexibility in setting its resonant frequency (natural vibration frequency), and thus allows the resonant frequency to be set so as to substantially coincide with the frequency of the flexural vibrations of the actuator 3, although it depends on the material and thickness of each member. Here, the dimensions of each elastic support portion 4 are designed such that its resonant frequency (natural vibration frequency) in the case where the beam portion 25 and the connection portions 27 and 28 are removed is substantially equal to the resonant frequency (natural vibration frequency) of the actuator 3.

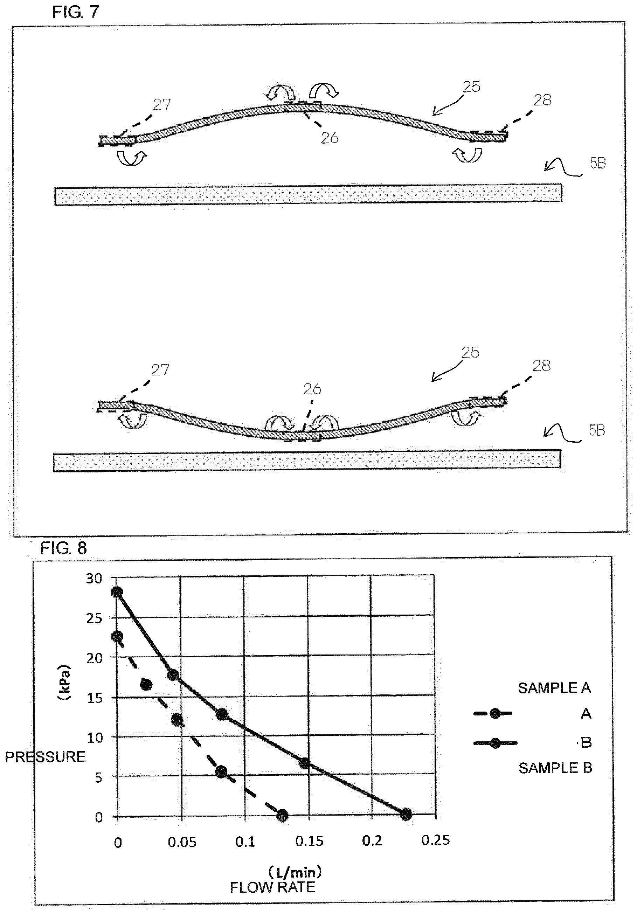

Fig. 7 is a schematic cross-sectional view illustrating a deformed state of the beam portion 25. When the resonant frequency of each elastic support portion 4 coincides with the resonant frequency (the frequency of the flexural vibrations) of the actuator 3, vibrations in the first-order resonance mode in which the connection portion 26 to the actuator is the antinode of the vibrations occur in the beam portion 25 with flexural vibrations of the actuator 3. In this case, the flexural vibrations of the actuator 3 are not damped by the beam portion 25, and the amplitude of the flexural vibrations of the actuator 3 can be increased (maximized).

In addition, in the beam portion 25, a moment load is applied to the connection portions 26, 27, and 28, which are connected to other members, in the directions indicated by arrows in the drawing. The respective connection portions 26, 27, and 28 are designed regarding the lengths of connection with the actuator 3 and the side wall such that breakage is not caused by the moment load. It should be noted that in the configuration, the beam portion 25 has an arc shape in a top view and is not folded back in its middle. In a folded-back shape (a meander shape, etc.), a moment load is applied to a folded-back portion so as to open the folded-back portion in the opposite vertical directions, and thus the elastic support portion is at high risk of breakage. However, it can be said that the piezoelectric pump 1, in which each beam portion 25 is configured to have no folded-back portion as in the present application, has a configuration in which the elastic support portion is difficult to break and breakdown is unlikely to occur.

It should be noted that even when the vibration mode of the beam portion 25 is an odd number-order resonance mode other than the first-order resonance mode such as the third- order resonance mode, damping of the flexural vibrations of the actuator 3 by the beam portion 25 can be suppressed. However, in a high-order resonance mode, the vibration amplitude of the beam portion 25 becomes small, and thus vibrations in the first-order resonance mode are most desirable.

It should be noted that the elastic support portions 4 are provided in three positions, but it suffices that the elastic support portions 4 are provided in at least two positions, and the elastic support portions 4 may be provided in more than three positions.

Use of the leaf spring 15 having such a configuration allows the amplitude of the flexural vibrations of the actuator 3 to be increased, whereby desired fluid pressure and flow rate can be efficiently obtained in the piezoelectric pump 1 even when the drive voltage is low.

Referring back to Fig. 5, the configuration of each of the other members will be described.

The housing top plate 11, the spacer 12, the power-supply plate 13, and the insulating spacer 14 constitute a housing on the upper surface side of the actuator 3, and openings 12A, 13A, and 14A provided in these members constitute an inner space on the upper surface side of the actuator 3.

The housing top plate 11 is a rectangular plate in which the flow path hole 6B is formed. The housing top plate 11 is preferably made of metal or resin. The flow path hole 6B is a discharge hole for releasing positive pressure within the housing and may be provided in any position in the housing top plate 11 but is provided in a position out of the centre of the housing top plate 11 in the present embodiment.

The spacer 12 is a rectangular plate made of resin in which the opening 12A is formed, and is provided between the housing top plate 11 and the power-supply plate 13. The power-supply plate 13 is a rectangular plate made of metal in which the opening 13A is formed, and includes a power-supply terminal 13B projecting inwardly in the opening 13A and an external connection terminal 13C projecting outwardly from a corner in the outer periphery. The power-supply terminal 13B is connected to an upper-surface electrode of the piezoelectric element 3B by means of soldering or the like, and the external connection terminal 13C is connected to a drive circuit. The insulating spacer 14 is a rectangular plate made of resin in which the opening 14A is formed, and serves to insulate the power-supply plate 13 and the leaf spring 15 from each other.

It should be noted that the thickness of the insulating spacer 14 is made slightly larger than the thickness of the piezoelectric element 3B, and the soldered position of the power-supply terminal 13B is set to a position corresponding to the node of the flexural vibrations of the actuator 3. Thus, it can be suppressed that the power-supply terminal 13B vibrates with the flexural vibrations of the actuator 3. Accordingly, damping of the flexural vibrations of the actuator 3 by the power-supply terminal 13B can be prevented. In addition, the thickness of the spacer 12 is set to such a thickness that even when the actuator 3 flexurally vibrates, the power-supply terminal 13B does not come into contact with the housing top plate 11 and a sufficient interval is kept therebetween. If the housing top plate 11 gets very close to the actuator 3, there is risk that the vibration amplitude of the actuator 3 will decrease due to the flow path resistance. Thus, by keeping the interval sufficient, decrease in the vibration amplitude of the actuator 3 can be prevented. With this configuration example, the thickness of the spacer 12 suffices to be nearly the same as that of the piezoelectric element 3B.

In addition, the spacer 17, the thin metal plate 18, and the frame plate 19 constitute a housing on the lower surface side of the actuator 3, and an opening 17A provided in the spacer 17 constitutes an inner space on the lower surface side of the actuator 3.

The spacer 17 is a rectangular plate in which the opening 17A is formed, and is provided for ensuring a space for locating the reinforcing plate 16. The thin metal plate 18 is a rectangular plate made of metal in which the flow path hole 6A is formed, and constitutes the lower opposed wall 5B described with reference to Fig. 2. The frame plate 19 is a rectangular plate made of metal in which an opening 19A is formed, and is provided for forming a thin portion and a thick portion in the lower opposed wall 5B.

Here, the thickness of the spacer 17 is made slightly larger than the thickness of the reinforcing plate 16 (by about 20 µm), and thus, the lower surface of the actuator 3 (the lower surface of the reinforcing plate 16) faces the upper surface of the thin metal plate 18 (the lower opposed wall 5B) across a small gap. The gap is automatically adjusted in response to load variation. When the load is low, the gap increases and the flow rate increases, and when the load is high, the elastic support portions 4 sag to decrease the gap, and required fluid pressure is ensured.

In addition, by joining the frame plate 19 to the thin metal plate 18, the thin portion and the thick portion are formed in the lower opposed wall 5B. In this configuration, the thin portion is preferably set such that its resonant frequency is substantially the same as or slightly lower than that of the actuator 3. Thus, the thin portion flexurally vibrates in response to pressure variation caused by vibrations of the actuator 3 such that its vibration phase shifts from the vibration phase of the actuator 3 (for example, a delay of 90°), and thus it is made possible to substantially increase the vibration amplitude in the interval between the actuator 3 and the lower opposed wall 5B to further enhance the pumping power. The thin metal plate 18 and the frame plate 19 may be made of resin, not metal. However, here, the thin metal plate 18 and the frame plate 19 are made of metal in order to achieve a resonant frequency that is substantially the same as that of the actuator 3.

Next, a result of a sample test conducted using the piezoelectric pump 1 having the configuration described above will be described with reference to Fig. 8. A sample A is a comparative sample in which the natural vibration frequency of the spring portion is intentionally shifted from the natural vibration frequency of the actuator. Specifically, in the sample A, the material of the leaf spring is phosphor bronze (C5210), the designed value of the natural vibration frequency of each elastic support portion is set to 17.4 kHz, and the natural vibration frequency of the actuator is set to about 20 kHz. Meanwhile, in a sample B, the material of the leaf spring is German silver (C7701), the designed value of the natural vibration frequency of each elastic support portion is set to 19.8 kHz, and the natural vibration frequency of the actuator is set to about 20 kHz.

In such a sample test, it was able to be confirmed that in the sample B in which the natural vibration frequency of each elastic support portion is made nearly equal to the natural vibration frequency of the actuator, the obtained fluid pressure and flow rate are increased more than in the sample A in which the natural vibration frequency of each elastic support portion is made different from the natural vibration frequency of the actuator, as shown in the drawing. This is considered to be because damping of flexural vibrations by each elastic support portion is suppressed.

Next, another configuration example of the leaf spring will be described.

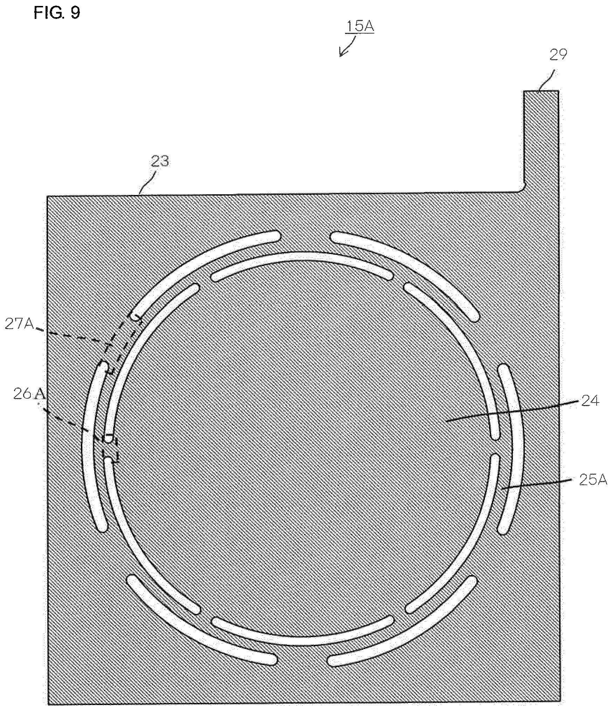

Fig. 9 is a plan view of a leaf spring 15A according to the other configuration example. The aforementioned leaf spring 15 includes the separately formed three elastic support portions 4, whereas the leaf spring 15A is configured to include an annular beam portion 25A, six side wall connection portions 27A arranged at intervals of 60°, and six actuator connection portions 26A arranged so as to be shifted from the side wall connection portions 27A by 30°.

Even in the present embodiment, when it is designed such that the resonant frequency (natural vibration frequency) of the elastic support portion is made to substantially coincide with the resonant frequency (natural vibration frequency) of the actuator and the elastic support portion vibrates in the first-order resonance mode or in a higher odd number-order resonance mode, flexural vibrations of the actuator can be prevented from being damped. It should be noted that the resonant frequency (natural vibration frequency) of the elastic support portion is not limited to completely coincide with the resonant frequency (natural vibration frequency) of the actuator, and may be shifted therefrom slightly in a range where the advantageous effect is provided.

### Second embodiment

Next, a piezoelectric pump 51 according to a second embodiment of the present invention will be described.

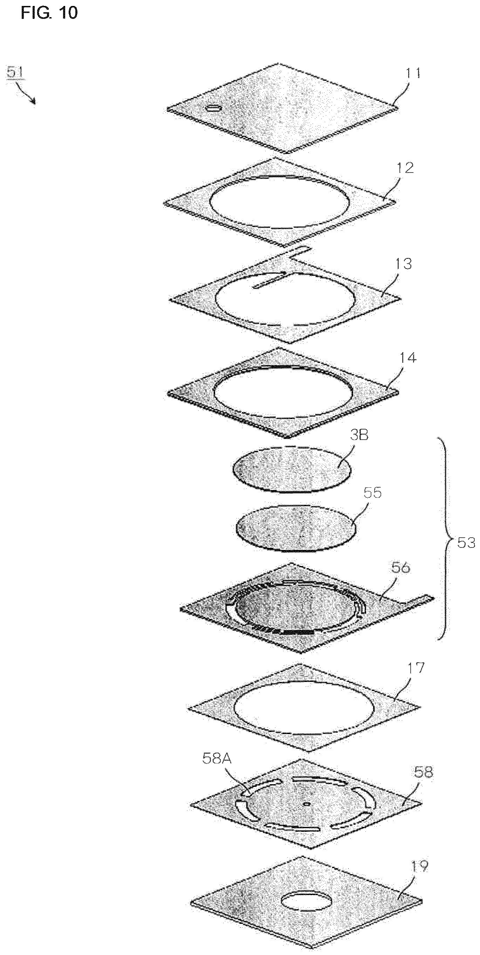

Fig. 10 is an exploded perspective view of the piezoelectric pump 51. The piezoelectric pump 51 includes an actuator 53 and a thin metal plate 58 each of which has a different configuration from that in the aforementioned first embodiment.

The actuator 53 is configured such that a piezoelectric element 3B, a reinforcing plate 55, a leaf spring 56, and a reinforcing plate 55 are laminated in the middle. In this case, it is necessary to appropriately reset the coefficient of linear expansion of each member, and it is preferred that a material having a sufficiently higher coefficient of linear expansion than those of the piezoelectric element 3B and the leaf spring 56 is used for the reinforcing plate 55. Preferably, for example, phosphor bronze, German silver, or the like, which is a material having a high coefficient of linear expansion, is used for the reinforcing plate 55, and SUS430 or the like, which is a material having a low coefficient of linear expansion, is used for the leaf spring. In this case, the Young's modulus of the leaf spring is high as compared to those of phosphor bronze and German silver, and thus the spring constant and the natural vibration frequency of the leaf spring are too high when the leaf spring has the same spring shape as that in the first embodiment. Therefore, in the configuration of the present embodiment, adjustment for reducing the natural vibration frequency is preferably performed by shape change such as making the slit portion longer than that in the first embodiment.

In addition, in the present embodiment, in the thin metal plate 58, relief holes 58A are formed in positions that face the elastic support portions of the leaf spring 56. The relief holes 58A serve to prevent interference between the leaf spring 56 and the thin metal plate 58. In the configuration of the present application, the elastic support portions vibrate in response to vibrations of the actuator, and in each elastic support portion, the vicinity of the connection portion to the actuator has the highest vibration amplitude. Although there is no problem in the aforementioned embodiment, when the reinforcing plate and the piezoelectric element are provided on the leaf spring as in the present embodiment, the interval between the leaf spring 56 and the thin metal plate 58 is only 20 µm, and there is a possibility that the elastic support portion will come into contact with the thin metal plate 58 during driving. Contact between the elastic support portion and the thin metal plate 58 is problematic, since it deteriorates the pressure-flow rate characteristic and causes unusual noise. Thus, by providing the relief holes 58A in the positions of the thin metal plate 58 that face the elastic support portions, interference between the elastic support portions and the thin metal plate 58 is avoided. It should be noted that a lifting effect by flow path resistance is exerted on the vicinity of the centre of the actuator, and thus contact with the thin metal plate 58 is unlikely to occur, which causes no problem.

It should be noted that the relief holes are provided in six positions in the drawing, and this is to be able to support leaf springs of various shapes. When three elastic support portions are provided as in the present embodiment, merely relief holes may be provided in the three corresponding positions, respectively.

### Other embodiments

In each embodiment described above, the unimorph type actuator is provided in which the piezoelectric element is disposed on a single surface of the leaf spring, but a bimorph type actuator may be configured in which piezoelectric elements are disposed on both surfaces of a leaf spring.

In addition, the actuator is not limited to the type including the piezoelectric element, and one that is driven by means of electromagnetic drive may be used as long as it flexurally vibrates.

In addition, the sizes of the piezoelectric element and the disc portion may be the same, or the disc portion may be larger than the piezoelectric element.

In addition, in the present invention, in applications in which occurrence of audible sound is not problematic, the actuator may be driven in an audible frequency band.

In addition, the configuration is not limited to the configuration in which one flow path hole 6A is provided, and a plurality of flow path holes 6A may be provided in a region that faces the actuator.

In addition, in each embodiment described above, the frequency of the drive voltage is set such that the actuator vibrates in the first-order mode, but the frequency of the drive voltage may be set such that the actuator vibrates in another mode such as the third-order mode.

In addition, in each embodiment described above, the disc-shaped piezoelectric element and the disc-shaped vibration plate are used, but one of them may be rectangular or polygonal.

It should be noted that the fluid to be sucked or sucked/discharged is not limited to a gas and may be a liquid.

### Reference Signs List

1, 51 piezoelectric pump
2 housing
3 actuator
3A vibration plate
3B piezoelectric element
4 elastic support portion
5 inner space
5A side wall
5B lower opposed wall
5C upper opposed wall
6A, 6B flow path hole
11 housing top plate
12, 17 spacer
14 insulating spacer
13 power-supply plate
13B power-supply terminal
13C external connection terminal
15, 15A, 15B leaf spring
16 reinforcing plate
18 thin metal plate
19 frame plate
12A, 13A, 14A, 17A, 19A opening
23 outer frame portion
24 disc portion
25, 25A, 25B beam portion
26, 27, 28, 26A, 27A connection portion
29 external connection terminal
53 actuator
55 reinforcing plate
56 leaf spring
58 thin metal plate
58A relief hole

## Claims

1. A pump device (1) comprising an actuator support structure, the actuator support structure comprising:
a plate-shaped actuator (3) which flexurally vibrates from a centre portion of a principal surface thereof to an outer peripheral portion thereof;
a side wall (2, 5A) which surrounds outside of an outer periphery of the actuator; and
an elastic support portion (4) which elastically supports the outer periphery of the actuator to the side wall, wherein
the elastic support portion (4) includes:
a beam portion (25), having a substantially circular arc shape, which extends in a gap between the actuator (3) and the side wall (2) in a direction along the outer periphery of the actuator;
an actuator connection portion (26) which connects the beam portion (25) to the actuator (3, 24); and
a side wall connection portion (27, 28) which is provided in a position offset from the actuator connection portion (26) in the direction along the outer periphery of the actuator and connects the beam portion to the side wall (2); and
wherein the side wall (2, 5A) of the actuator support structure is included in a housing (2) of the pump device, the housing (2) also including an opposed wall (2, 5C) which is located so as to be adjacent to and opposed to the principal surface of the actuator; and wherein the opposed wall (2, 5C) is provided with a flow path hole (6A) in a centre of a region facing the actuator or in the vicinity of the centre, through which flow path hole (6A) a fluid flows in.

2. The pump device according to claim 1, wherein the beam portion (25) is configured to be connected to the actuator (3) via the actuator connection portion (26) at a position adjacent to an antinode of natural vibrations when the side wall connection portion (27) is a fixing portion, and a natural vibration frequency of the natural vibrations coincides with a natural vibration frequency of the actuator.

3. The pump device according to claim 2, having two side wall connection portions (27,28) each connected to a respective end of the beam portion (25), and the actuator connection portion (26) is connected to a centre of the beam portion (25) between both ends thereof.

4. The pump device according to claim 2 or 3, wherein vibrations of the beam portion (25) accompanying the flexural vibrations of the actuator are vibrations in a first-order resonance mode.

5. The pump device according to any one of claims 1 to 4, wherein the actuator (3) has a disc shape.

6. The pump device according to any one of claims 1 to 5, wherein the opposed wall includes: a thin portion which is provided on an outer periphery of the flow path hole and capable of flexurally vibrating; and a thick portion which is provided on an outer periphery of the thin portion.

## Patentansprüche

1. Pumpvorrichtung (1), die eine Stellgliedstützstruktur umfasst, wobei die Stellgliedstützstruktur Folgendes umfasst:
ein plattenförmiges Stellglied (3), das biegsam von einer Mittelposition einer Hauptoberfläche davon zu einem äußeren Umfangsabschnitt davon vibriert;
eine Seitenwand (2, 5A), die das Stellglied außerhalb eines äußeren Umfangs umgibt;
und
einen elastischen Stützabschnitt (4), der elastisch den äußeren Umfang des Stellglieds zu der Seitenwand hin unterstützt, wobei
der elastische Stützabschnitt (4) Folgendes einschließt:
einen Balkenabschnitt (25), der im Wesentlichen eine Kreisbogenform aufweist, die sich in einer Lücke zwischen dem Stellglied (3) und der Seitenwand (2) in einer Richtung entlang des äußeren Umfangs des Stellglieds erstreckt;
einen Stellgliedverbindungsabschnitt (26), der den Balkenabschnitt (25) des Stellglieds (3, 24) verbindet; und
einen Seitenwandverbindungsabschnitt (27, 28), der in einer Position versetzt zu dem Stellgliedverbindungsabschnitt (26) in der Richtung entlang des äußeren Umfangs des Stellglieds vorgesehen ist und den Balkenabschnitt mit der Seitenwand (2) verbindet; und
wobei die Seitenwand (2, 5A) der Stellgliedstützstruktur in einem Gehäuse (2) der Pumpvorrichtung eingeschlossen ist, wobei das Gehäuse (2) auch eine gegenüberliegende Wand (2, 5C) einschließt, die so platziert ist, dass sie sich angrenzend an und gegenüberliegend der Hauptoberfläche des Stellglieds befindet; und wobei die gegenüberliegende Fläche (2, 5C) mit einer Fließwegöffnung (6A) in einem Mittelpunkt eines dem Stellglied zugewandten Bereichs oder in der Nähe des Mittelpunkts vorgesehen ist, wobei durch diese Fließwegöffnung (6A) eine Flüssigkeit einströmt.

2. Pumpvorrichtung nach Anspruch 1, wobei der Balkenabschnitt (25) dazu ausgestaltet ist, mit dem Stellglied (3) über den Stellgliedverbindungsabschnitt (26) in einer Position verbunden zu werden, die an eine Antinomie von Eigenvibrationen angrenzt, wenn der Seitenwandverbindungsabschnitt (27) ein Fixierungsabschnitt ist, und wobei eine Eigenvibrationsfrequenz der Eigenvibrationen mit einer Eigenvibrationsfrequenz des Stellglieds zusammenfällt.

3. Pumpvorrichtung nach Anspruch 2, die zwei Seitenwandverbindungsabschnitte (27, 28) aufweist, die beide mit einem jeweiligen Ende des Balkenabschnitts (25) verbunden sind, und wobei der Stellgliedverbindungsabschnitt (26) mit einem Mittelpunkt des Balkenabschnitts (25) zwischen beiden Enden davon verbunden ist.

4. Pumpvorrichtung nach Anspruch 2 oder 3, wobei Vibrationen des Balkenabschnitts (25), die die biegsamen Vibrationen des Stellglieds begleiten, Vibrationen in einem Resonanzbetrieb erster Ordnung sind.

5. Pumpvorrichtung nach einem der Ansprüche 1 bis 4, wobei das Stellglied (3) eine Scheibenform aufweist.

6. Pumpvorrichtung nach einem der Ansprüche 1 bis 5, wobei die gegenüberliegende Wand Folgendes einschließt: einen dünnen Abschnitt, der an einem äußeren Umfang der Fließwegöffnung vorgesehen ist und biegsam vibrieren kann; und einen dicken Abschnitt, der an einem äußeren Umfang des dünnen Abschnitts vorgesehen ist.

## Revendications

1. Dispositif de pompe (1) comprenant une structure de soutien d'actionneur, la structure de soutien d'actionneur comprenant :
un actionneur en forme de plaque (3) qui vibre par flexion d'une partie centrale d'une surface principale à une partie périphérique extérieure de celui-ci ;
une paroi latérale (2, 5A) qui entoure l'extérieur d'une périphérie extérieure de l'actionneur ;
et
une partie de soutien élastique (4) qui soutient élastiquement la périphérie extérieure de l'actionneur de la paroi latérale,
la partie de soutien élastique (4) comprenant :
une partie (25) formant une poutre, comportant une forme arquée sensiblement circulaire, qui s'étend dans un intervalle entre l'actionneur (3) et la paroi latérale (2) dans une direction le long de la périphérie extérieure de l'actionneur ;
une partie de liaison (26) avec l'actionneur qui relie la partie (25) formant une poutre à l'actionneur (3, 24) ; et
une partie de liaison (27, 28) avec la paroi latérale qui est prévue dans une position décalée de la partie de liaison (26) avec l'actionneur dans la direction le long de la périphérie extérieure de l'actionneur et qui relie la partie formant une poutre à la paroi latérale (2) ; et
la paroi latérale (2, 5A) de la structure de soutien d'actionneur faisant partie d'un boîtier (2) du dispositif de pompe, le boîtier (2) comprenant aussi une paroi opposée (2, 5C) qui est disposée de manière à être adjacente à la surface principale de l'actionneur et opposée à cette dernière ; et la paroi opposée (2, 5C) étant dotée d'un trou d'écoulement de flux (6A) au centre d'une région qui fait face à l'actionneur ou au voisinage du centre, trou d'écoulement de flux (6A) à travers lequel un fluide entre en s'écoulant.

2. Dispositif de pompe selon la revendication 1, dans lequel la partie (25) formant une poutre est conçue pour être reliée à l'actionneur (3) par le biais de la partie de liaison (26) avec l'actionneur en une position adjacente à un ventre de vibrations naturelles quand la partie de liaison (27) avec la paroi latérale est une partie de fixation, et qu'une fréquence de vibration naturelle des vibrations naturelles coïncide avec une fréquence de vibration naturelle de l'actionneur.

3. Dispositif de pompe selon la revendication 2, comportant deux parties de liaison (27, 28) avec la paroi latérale, chacune étant reliée à une extrémité respective de la partie (25) formant une poutre, et la partie de liaison (26) avec l'actionneur est reliée à un centre de la partie (25) formant une poutre entre ses deux extrémités.

4. Dispositif de pompe selon la revendication 2 ou 3, dans lequel les vibrations de la partie (25) formant une poutre accompagnant les vibrations par flexion de l'actionneur sont des vibrations d'un mode de résonance de premier ordre.

5. Dispositif de pompe selon l'une quelconque des revendications 1 à 4, dans lequel l'actionneur (3) a la forme d'un disque.

6. Dispositif de pompe selon l'une quelconque des revendications 1 à 5, dans lequel la paroi opposée comprend : une partie fine, qui se trouve sur une périphérie extérieure du trou de voie d'écoulement et à même de vibrer par flexion ; et une partie épaisse, qui se trouve sur une périphérie extérieure de la partie fine.
